# EUROPEAN PATENT APPLICATION

(11) **EP 2 269 890 A2**
(43) Date of publication of application: **05.01.2011**
(21) Application number: 10165216.2
(22) Date of filing: 08.06.2010
(51) Int. Cl.: B62B 3/04

(54) **Mount jig and elevating lift**

(30) Priority: 30.06.2009 JP 2009154563
(71) Applicant: Fujitsu Limited, Kawasaki-shi, Kanagawa 211-8588 (JP)
(72) Inventor: Takahasi, Tetsuya, Kawasaki-shi, Kanagawa 211-8588 (JP); Nakamura, Koichi, Kawasaki-shi, Kanagawa 211-8588 (JP)
(74) Representative: Stebbing, Timothy Charles

(57) **Abstract**

The present application is a technique to be used for mounting a heavy article to be mounted from a packed body to a rack or the like. In this application, a mounting jig is used for a moving and installation procedure, the mounting jig including a cover member (2) that is detachably secured to a table (101) of a lift trolley (100) having an article (50) to be mounted placed thereon for transportation, the cover member covering an upper surface of the table (101), an upper surface of the cover member (2) being provided with a low friction treatment.

## Description

The present application relates to a mount jig (mounting jig) and an elevating lift (lift trolley) used for mounting a heavy article to be mounted from a packed body on a rack or the like.

Conventionally, transportation enclosed bodies (containers) and packing boxes have been used for transporting articles. For example, a transportation enclosed body has been known which includes a palette and an outer box attached to the top of the palette (see Patent Reference 1). In addition, a packing box formed by a bent plate material (sheet material) has been known, which includes a rectangular bottom plate, four side walls, and a lid section of an upper surface, where one of the side walls, as well as the lid section, can be opened (see Patent Reference 2).
Patent Reference 1: Japanese Laid-open Patent Publication No. 2005-153917
Patent Reference 2: International Publication No. WO 01/00494

However, no particular attention has been paid to such transportation enclosed bodies and packing boxes, in a case where an article to be packed (article to be mounted) are installed high up, in other words at an elevated location, or that the article to be packed are heavy and an elevating lift (such as a lift trolley or hoist trolley) is used to raise the article to an elevated location, such as a rack.

When an article to be packed that is enclosed in a transportation enclosed body or packing box is to be installed at an elevated location using an elevating lift, and an operator raises the article to be packed on a table of the elevating lift by hand, then depending on the weight of the article a lot of operators may be required for the movement.

However, having many operators on the site where the article is to be installed is not always possible. In addition, an apparatus for moving the article to be packed into the table of the elevating lift is not always available. Thus, the article to be packed is divided into a plurality of parts and the divided parts are installed one by one.

In such a case, packing is performed for each of the divided parts. Individual packing may complicate the packing procedure. In addition, packing materials and packing volumes are increased, which results in increase in the transportation cost. They also put burden on the global environment.

Furthermore, individual packing also complicates the unpacking procedure. As a result, setup time on the site at which the article to be packed is installed is increased.

In addition, when performing unpacking and setup on site, the following issues may be encountered. When the article to be packed to be set up is an apparatus made of a large number of electronic devices interconnected with each other, the apparatus is assembled at a factory or the like. The assembled apparatus undergoes various tests to check whether the apparatus operates normally, before being shipped. At this time, various cables (connectors) connecting among the electronic devices and the apparatus main body are temporarily disconnected. The disconnected cables are reconnected on the site. The cable reconnection procedure on the site cannot assure the reliability of the procedure for that apparatus undergoes that disconnection. Any misconnection of cables among the electronic devices and the apparatus main body may cause failure of the apparatus.

Considering such situations, the present applicants propose a packed body that has a base section having an article placement surface which is positioned higher than a table surface of a table when the table of the elevating lift is lowered. In such a packed body, the article to be packed is shipped while being placed and secured on the article placement surface of the base section covered with an exterior member. At the shipped location, after the exterior member is removed, the elevating lifter is moved adjacent to the above-described packed body while the table surface of the elevating lifter is adjusted to be the level of the article placement surface of the above-described packed body. At this time, the article to be packed is placed on the article placement surface having the sliding member interposed therebetween. The article to be packed is moved to and placed on the table surface of the elevating lifter by slidably displacing the sliding member from the packed body to the elevating lifter. The article to be packed placed in this manner on the table surface is transferred, as a part to be mounted, by the elevating lifter to a rack or the like, and mounted by slidable displacement from the elevating lifter to the rack or the like.

By using the above-described packed body, even if the article to be packed is a heavy article, the article to be packed can be easily moved to the elevating lift without requiring individual packing of divided parts and without lifting the article. Thus, the various situations described above can be addressed.

However, usually, since a table surface of an elevating lift is usually provided with a member, such as rubber, in order to prevent an article on the table surface from being damaged or dropped, the friction during slidable displacement is increased. Accordingly, the task for slidably displacing a heavy article on a table surface is increasingly getting harder. In particularly, recently, the weights of articles to be packed/articles to be mounted is increased with an increase in the packaging density of electronic devices, the task of slidable displacement is becoming more difficult.

Accordingly, it is desirable to facilitate the procedure for moving an article to be mounted onto an elevating lift, or the procedure for moving and installing the article to be mounted from the elevating lift to a raised installation position such as in a rack, even if the article to be mounted is a heavy article.

A mount jig embodying the present invention includes a cover member that is detachably secured to a table of a vertical lift (lift trolley, hoist trolley) transporting an article to be mounted, the article being placed on the table, the cover member covering an upper surface of the table, an upper surface of the cover member being provided with a low friction treatment.

An elevating lift embodying the invention includes the above-described mount jig on a table.

According to the disclosed technique, by covering the upper surface of the table of the elevating lift with the mount jig (cover member), it is possible to make the table surface of the elevating lift to be slidable irrespective of the presence of a member such as rubber. Thereby, the procedure for moving an article to be mounted onto an elevating lift, or the procedure for moving and installing the article to be mounted from the elevating lift to the rack even if the article to be mounted is a heavy article are facilitated.

Reference is made, by way of example only, to the accompanying drawings in which:
FIG. 1 is a perspective view illustrating a mount jig;
FIGS. 2A-2C illustrate a mount jig, wherein FIG. 2A is a plan view thereof, FIG. 2B is a left side view, and FIG. 2C is a rear view.
FIG. 3 is a perspective view illustrating a mount jig, an elevating lift, a sliding member, and an article to be mounted, depicting an exploded perspective view of the article mounted on the elevating lift (as depicted in FIG. 14);
FIG. 4 is a side view illustrating a first variant of the shape of the rising surfaces of the two sides of the recess;
FIG. 5 is a side view illustrating a second variant of the shape of the rising surfaces of the two sides of the recess and the shape of the two sides of the sliding member;
FIG. 6 is a side view illustrating a third variant of the shape of the rising surfaces of the two sides of the recess and the shape of the two sides of the sliding member;
FIG. 7 is a perspective view illustrating a variant of an attachment structure of a restricting member;
FIG. 8 is a perspective view illustrating a variant of a restricting member;
FIG. 9 is a perspective view illustrating an article to be mounted;
FIG. 10 is an exploded perspective view of a packed body of the article to be mounted;
FIG. 11 is a perspective view wherein the lid section of the exterior member of the packed body is opened and, the manual and the rack kit accommodated therein are removed;
FIG. 12 is a perspective view wherein the buffer member of above the article to be mounted is removed and the joints are removed from the packed body;
FIG. 13 is a perspective view wherein the buffer members in front and back of the article to be mounted and the level of the table of the elevating lift are adjusted after the exterior member of the packed body are removed;
FIG. 14 is a perspective view wherein the article to be mounted is mounted from the packed body onto the elevating lift.
FIG. 15 is a perspective view wherein handles on the article to be mounted are removed while the rear portion of the article to be mounted is protruded from the table;
FIG. 16 is an enlarged side view illustrating the main portion of FIG. 15;
FIG. 17 is a perspective view wherein the article to be mounted are mounted from the elevating lift onto the rack; and
FIG. 18 is a perspective view wherein the buffer member, a reinforcing sheet, and a partitioning member are removed from the base section of the packed body, and a power supply connector is removed.

Hereinafter, embodiments of the present invention will be described with reference drawings.

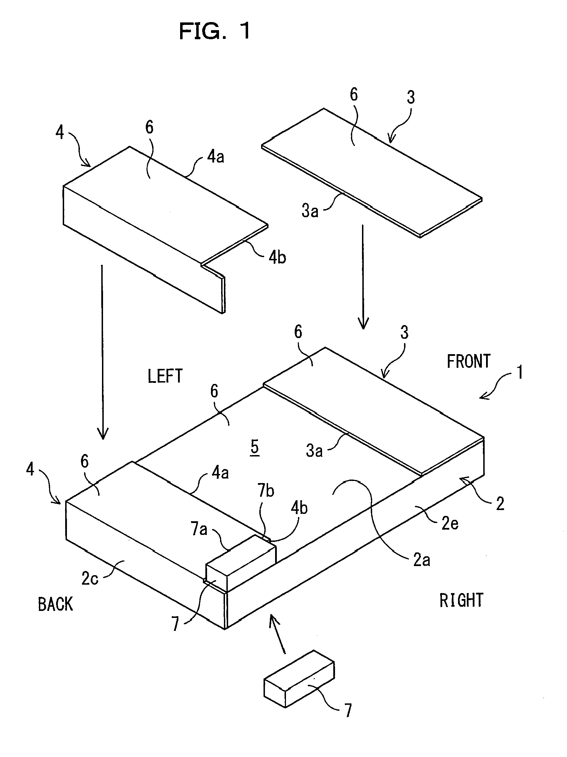

FIGS. 1-18 are drawings illustrating this embodiment.

### (1) Configuration of Mount Jig

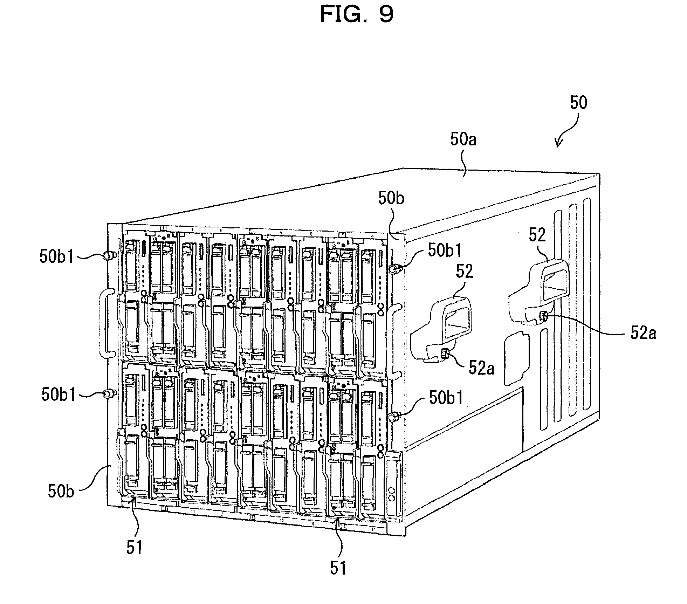

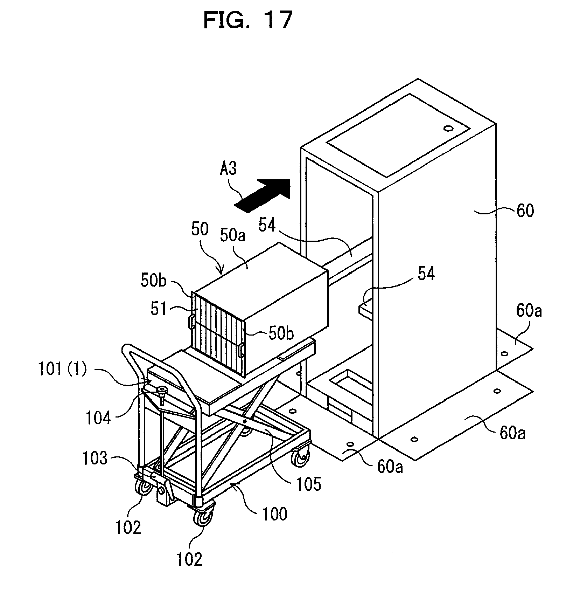

A mount jig 1 of this embodiment, which will be described with reference to FIGS. 1-8, has a product 50 depicted in FIG. 9 as an article to be mounted. FIG. 9 is a perspective view illustrating the product 50. The product 50 is used for a plurality of electronic devices 51 incorporated therein. The electronic devices 51 are incorporated in the main body 50a of the product 50. The product 50 is used while mounted in a rack 60 (see FIG. 17). The main body 50a is a box-shaped chassis. Each of the electronic devices 51 is a server blade incorporated into a chassis 50a. The rack 60 is a housing capable of accommodating a plurality of chassis 50a having server blades 51 incorporated therein.

It should be noted that two handles 52 are attached to each lateral side of the main body 50a of the product 50 by the attachment bolts 52a. The handles 52 are grabbed by an operator upon mounting of the product 50, and are removed before the product 50 is mounted to the rack 60, as described below. In addition, rack attachment sections 50b are projected outwardly towards the main body 50a on the two lateral sides of the front face opening of the main body 50a. Each rack attachment section 50b has two attachment bolts 50b1, and the attachment bolts 50b1 are threaded into threaded holes (not illustrated) in the rack 60 when the product 50 is secured to the rack 60.

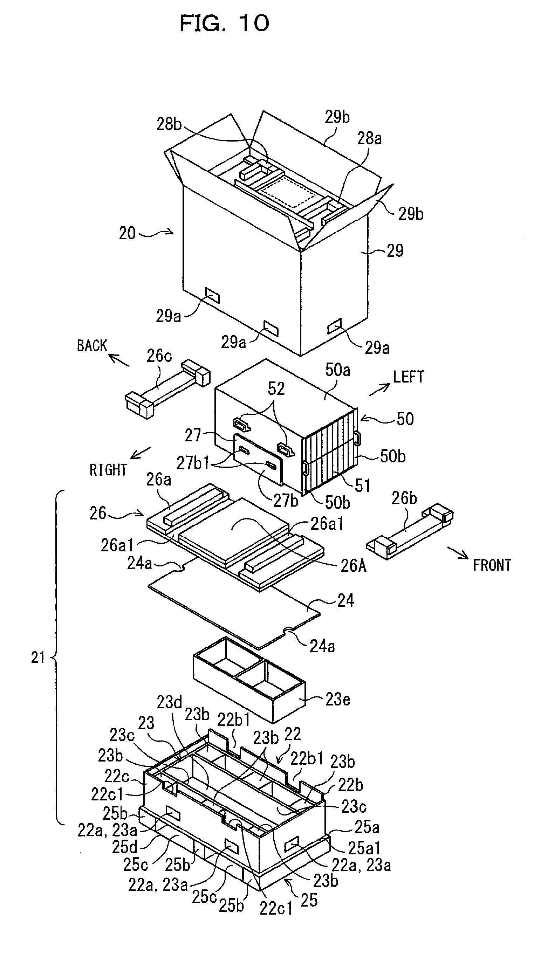

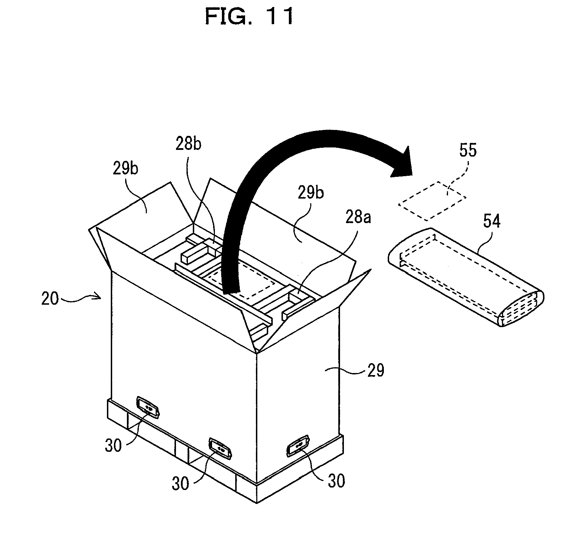

Electronic devices 51 are packed in a packing box (packed body) 20, which will be described later with reference to FIGS. 10-12, as the product 50 incorporated into the main body 50a, shipped and transport from a factory. After the transportation of the packing box 20, the procedures to unpack the packing box 20 and to mount the product 50 packed in the packing box 20 into the rack 60 will be described later with reference to FIGS. 11-18.

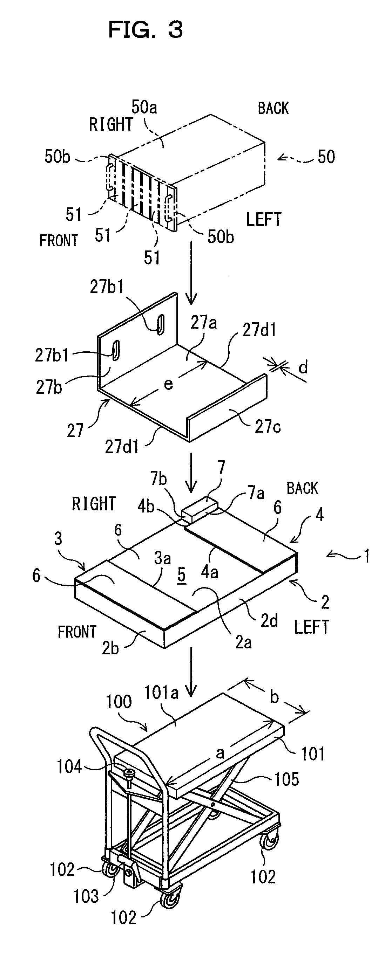

When mounting and installing the product 50 into the rack 60, an elevating lift 100 (lift trolley or hoist trolley) as depicted in FIGS. 3, 13-15, and 17 is used. The elevating lift 100 receives the product 50 therein, and is used to transfer the product 50 and lift it to an elevated location, such as a rack, for installation. The elevating lift 100 includes a table 101, wheels 102, a foot pedal 103, a handle 104, and a link mechanism 105. The table 101 is configured to be elevatable by the link mechanism 105, and receives the product 50 or the like on a table surface 101a thereof on the upper surface thereof. The wheels 102 have a lock function being capable of being locked by an operation or the like. The foot pedal 103 is depressed by a foot of the operator in an attempt to elevate the table 101 (the product 50 or the like) using the link mechanism 105. The handle 104 is rotated by a hand of the operator in an attempt to lower the table 101 (the product 50 or the like) using the link mechanism 105. It should be noted that elevating lifter 100 may include a hydraulic mechanism, in place of the link mechanism 105.

The mount jig 1 of this embodiment is installed on the table 101 of the elevating lift 100 so as to cover the table surface 101a, as depicted in FIGS. 3, 13-15, and 17, when the product 50 is transferred from the packing box 20 to the rack 60 for mounting into the rack 60.

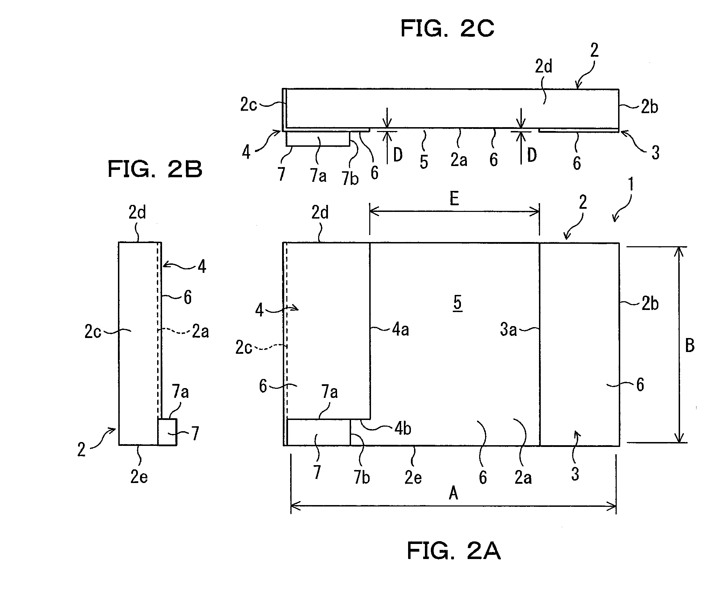

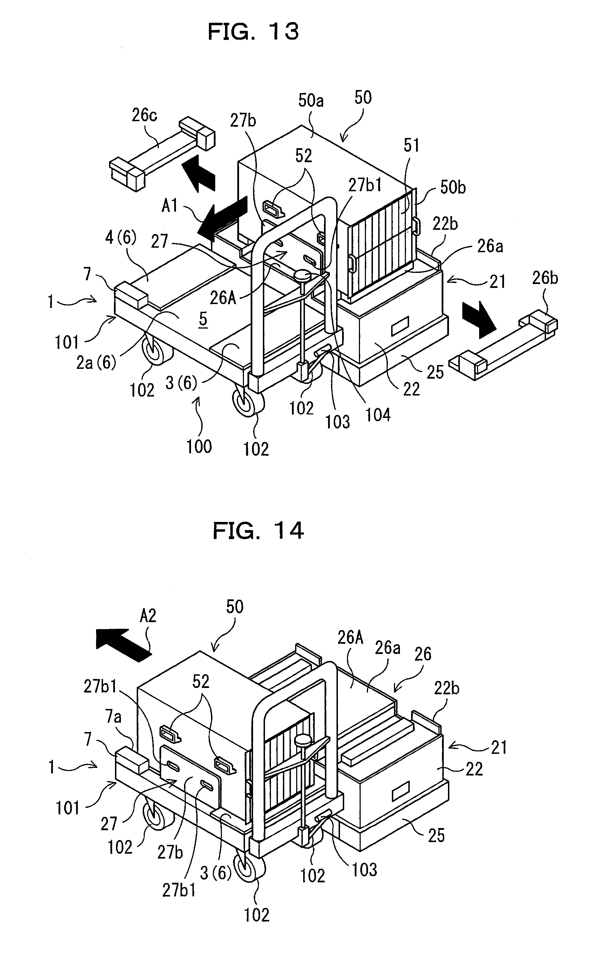

Firstly, the entire configuration of the mount jig 1 will be described with reference to FIGS. 1-3. It should be noted that, in the following description, the front, the rear, the left, and the right of the jig 1 are defined as depicted in FIG. 1 or FIG. 3 for ease of description. FIG. 1 is a perspective view illustrating the mount jig 1, FIG. 2A is a plan view of the mount jig 1, FIG. 2B is a left side view of the mount jig 1, and FIG. 2C is a rear view of the mount jig 1. In addition, FIG. 3 is a perspective view illustrating the mount jig 100, the elevating lift 100, a sliding member 27 (which will be described later), and the product 50, depicting an exploded perspective view of the product 50 mounted on the elevating lift 100 (as depicted in FIG. 14).

As depicted in FIGS. 1-3, the mount jig 1 includes a cover member 2, a front-side sheet member 3, a rear-side sheet member 4, a low friction sheet 6, and a block 7.

The cover member 2 includes an upper surface 2a which is a rectangular surface similar to the shape of the table surface 101a of the elevating lift 100. The cover member 2 includes four surfaces vertically connected to the upper surface 2a, i.e., a front face 2b, a back face 2c, a left face 2d, and a right face 2e, and defines a lid-like shape. The heights of the front face 2b, the back face 2c, the left face 2d and the right face 2e are set to be the same or substantially the same as the height (depth) of the table 101 of the elevating lift 100. The vertical inner dimension (length) A that is the inner spacing (distance) between the front face 2b and the back face 2c (see FIG. 2A) is set to be slightly greater than the vertical dimension (length) "a" of the table 101 (see FIG. 3). Similarly, the lateral inner dimension (width) B that is inner spacing (distance) between the left face 2d and the right face 2e (see FIG. 2A) is set to be slightly greater than the lateral dimension (width) "b" of the table 101 (see FIG. 3). By having such dimensions, the cover member 2 is configured to have an inner shape (define an interior recess) that can mate with the outer shape of the table 101 from the top. The cover member 2 is installed on the table 101 of the elevating lift 100 while being mated with the table 101 from the top (the cover member is placed over the table). While being installed in this manner, the table surface 101a is covered by the cover member 2 (the mount jig 1) from the top and the cover member 2 (the mount jig 1) is detachably secured to the table 101. Thereby, regardless of the status of the table surface 101a, it is possible to maintain the placement surface of the product 50 in the elevating lift 100 in the same status, that is, the status of the upper surface of the mount jig 1. In other words, the properties of the surface on which product 50 is placed are controllable. It should be noted that, although the cover member 2 (the mount jig 1) may be secured to the table 101 by making it to mate it into the table 101, the cover member 2 (the mount jig 1) can also be secured by applying it with tape or a screw.

The front-side sheet member 3 and the rear-side sheet member 4 having a certain thickness D is provided on the upper surface of the cover member 2 (the upper surface 2a) (see FIG. 2C). The front-side sheet member 3 is applied and secured to the front side of the upper surface 2a of the cover member 2 using an adhesive material or tape or the like. Similarly, the rear-side sheet member 4 is applied and secured to the rear side of the upper surface 2a of the cover member 2 using an adhesive material or tape or the like. Thereby, a recess 5 is defined between the front-side sheet member (protrusion) 3 and the rear-side sheet member (protrusion) 4 on the upper surface 2a of the cover member 2. The rising surface (raised edge) 3a of the front-side sheet member 3 and the rising surface 4a of the rear-side sheet member 4 are planes that are orthogonal to the upper surface 2a and are parallel to the lateral direction, and face each other across the recess 5. It should be noted that, although the recess 5 is defined by applying the sheet members 3 and 4 on the cover member 2 in the mount jig 1 of this embodiment, the cover member 2 having the recess 5 as depicted in FIGS. 1-3 may be formed by mold casting using a reinforced plastic or the like.

The upper surface 2a of the recess 5, the upper surface of the front-side sheet member 3, and the upper surface of the rear-side sheet member 4 (that is, the upper surface of the cover member 2) are provided with a low friction treatment. In this embodiment, the low friction treatment is provided on the upper surface of the cover member 2 by applying the low friction sheet 6, which is a material having a lower friction coefficient, on the upper surface of the cover member 2 using double-sided tape or the like, thereby providing a low friction treatment section. A Mylar® sheet is used for the low friction sheet 6, for example. It should be noted that, when a reinforced plastic material is used for the cover member 2 or the sheet member 3 or 4, for example, the outer surface of that reinforced plastic material can be used as a low friction treatment section without requiring use of any low friction sheet 6.

The recess 5 is defined along the lateral direction, and engages with a slide tray 27 (i.e., is mated with the slide tray 27), thereby guiding the slide tray 27 to a first sliding direction (direction of Arrow A1 in FIG. 13), i.e., to the right direction. The slide tray 27 is a plate-shape sliding member that slidably displaces the product 50 to the first sliding direction, with the product 50 placed thereon. The slide tray 27 is formed from corrugated cardboard (for example AA flute, AB flute) used as a packing material or a support member for a heavy article. The slide tray 27 includes, as depicted in FIG. 3, a central planar portion 27a for receiving the product 50, and a left-side flap 27c and a right-side flap 27b continuously formed with the lateral sides of the planar portion 27a. The slide tray 27 is made from one sheet of corrugated cardboard. The central portion of the one sheet of corrugated cardboard is used as the planar portion 27a, and the left-side flap 27c and the right-side flap 27b are formed by bending the two ends of the sheet of corrugated cardboard. The right-side flap 27b is formed so as to be longer than the left-side flap 27c. A pair of handling holes 27b1 is formed in the right-side flap 27b. Although the handling holes 27b1 are formed in an oval shape elongated in the lateral direction (the vertical direction in FIG. 3) in the example depicted in FIG. 3, they may be formed in an oval shape elongated in the front-and-back direction, as depicted in FIGS. 13-15. An operator can easily slidably displace the product 50 to the first sliding direction (right direction) by holding the handling holes 27b1 and pulling the slide tray 27 to the right direction. It should be noted that the side sections 27d1 of the slide tray 27 are formed as planes (rising surface) orthogonal to the planar portion 27a, and the flaps 27b and 27c. When the slide tray 27 is engaged with the recess 5 and guided, the rising surfaces 27d1 of two sides of the slide tray 27 oppose to the rising surface 3a of the front-side sheet member 3 and the rising surface 4a of the rear-side sheet member 4, respectively.

Here, the height of the protrusions 3 and 4 of the two sides of the recess 5 with respect to the bottom of the recess 5 (the upper surface 2a), that is, the thickness D of the sheet members 3 and 4, is set so as to be the same as the height/thickness "d" (see FIG. 3) of the slide tray 27 or slightly higher than the height "d". Thereby, when the product 50 is slidably displaced and the sheet members 3 and 4 are deformed due to the load applied to the sheet members 3 and 4 caused by the weight of the product 50, the load is substantially evenly applied on the slide tray 27 and the sheet members 3 and 4. In addition, in this embodiment, after the product 50 is transferred from a base section 21 (see FIG. 10, for example) onto the table 101 of the elevating lift 100 using the slide tray 27, the product 50 is displaced to a second sliding direction (direction of Arrow A2 in FIG. 14), i.e., to the rear direction. Thus, by setting the thickness D of the sheet members 3 and 4 so as to be the same as the thickness "d" or slightly higher than the height "d", it is possible to smoothly pass the product 50 from the slide tray 27 onto the rear-side sheet member 4 when displacing the product 50 to the second sliding direction.

In addition, the width of the recess 5, i.e., the spacing E between the rising surface 3a of the front-side sheet member 3 and the rising surface 4a of the rear-side sheet member 4 (see FIG. 2B) is set so as to be slightly wider than the width "e" of the slide tray 27 (see FIG. 3). Thereby, the slide tray 27 having the product 50 placed thereon is slidably displaced to the first sliding direction while the side portions (rising surface) 27d1 of the slide tray 27 is abutted against one of the rising surfaces 3a and 4a of the sheet members 3 and 4. Thus, the slide tray 27 (the product 50) is reliably guided and displaced to the first sliding direction without tilting with respect to the first sliding direction.

The product 50 of this embodiment is transferred onto the mount jig 1 of the elevating lift 100 by sliding it from the base section 21 using the slide tray 27. The upper surface of the mount jig 1 is provided with a low friction treatment to be easily slidable, thereby facilitating transferring the product 50. However, being much easily slidable may increase the risk of the product 50 that is being forcefully slidably displaced being fall from the elevating lift 100.

Thus, a cutout section 4b is formed on the right side of the rear-side sheet member 4, and a block (restricting member) 7 is attached on the upper surface 2a exposed by the cutout section 4b using an adhesive material or double-sided tape or the like. That is, the block 7 is formed so as to project on the corner upper surface on the rear right side of the mount jig 1 (the table 101). The block 7 is a box-shaped restricting member having a first restricting surface 7a and a second restricting surface 7b. The first restricting surface 7a is adapted to restrict any displacement of the product 50 to the first slide direction (right direction) by abutting against the right-side surface of the product 50, and the left-side surface of the block 7 defines the first restricting surface 7a on a plane that is orthogonal to the upper surface 2a and is parallel to the lateral direction. By restricting any displacement of the product 50 to the first slide direction by the first restricting surface 7a, not only any drop of the product 50 can be prevented, but alignment of the center axis of the table 101 of the elevating lift 100 (front-and-back direction axis) with the center axis of the product 50 (front-and-back direction axis) is facilitated. After restricting any displacement of the product 50 to the first slide direction, the first restricting surface 7a can also function as a guiding surface for slidably displacing the product 50 to the second slide direction (rear direction).

In addition, upon displacing the product 50 to the second slide direction so as to mount it from the elevating lift 100 to the rack 60, the second restricting surface 7b is adapted to restrict any displacement of the product 50 to the second slide direction by abutting against the right-side rack attachment section 50b of the product 50. The front end surface of the block 7 defines the second restricting surface 7b. By restricting any displacement of the product 50 to the second slide direction by the second restricting surface 7b, the entire weight of the product 50 is prevented from being applied abruptly from the elevating lift 100 to the rack 60 when the product 50 is mounted onto the rack 60. This can prevent problems, such as an abrupt upward movement of the elevating lift 100, hitting to the product 50. It should be noted that the block 7 is made from a soft material, such as a polyethylene foam, rubber, for example, thereby ensuring that any damage to the product 50 is prevented when the product 50 touches the block 7.

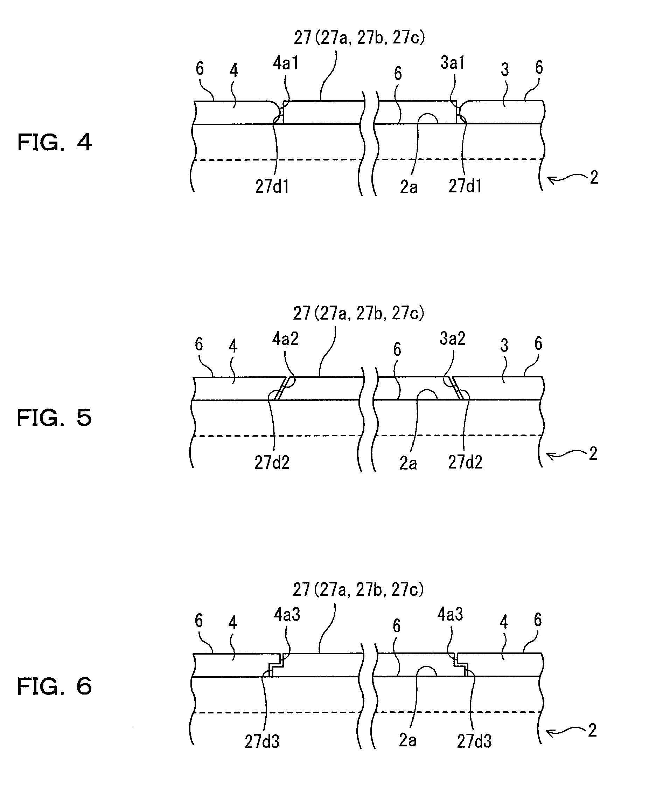

Next, a variant of the mount jig 1 will be described with reference to FIGS. 4-8.

FIG. 4 is a side view illustrating a first variant of the shape of the rising surfaces of the two sides of the recess 5. In the mount jig 1 depicted in FIGS. 1-3, the rising surfaces 3a and 4a of the two sides of the recess 5 is formed as a plane orthogonal to the upper surface 2a. In contrast, the first variant depicted in FIG. 4, rising surfaces 3a1 and 4a1 of the two sides of the recess 5 opposing to rising surfaces 27d1 of slide tray 27 has a convex shape (hemi-circle cross-sectional shape) projecting toward the slide tray 27. The contact resistance between the rising surfaces 3a1 and 4a1 of the two sides of the recess 5 and the rising surface 27d1 of the slide tray 27 is reduced by forming the rising surfaces 3a1 and 4a1 of the two sides of the recess 5 into the convex shape. Accordingly, the slide tray 27 can be displaced to the first slide direction (right direction) more smoothly.

FIG. 5 is a side view illustrating a second variant of the shape of the rising surfaces of the two sides of the recess 5 and the shape of the two sides of the slide tray 27. In the second variant depicted in FIG. 5, rising surfaces 27d2 of the slide tray 27 (cross-sectional shape orthogonal to the first slide direction) has a widened shape that linearly widens downward. Rising surfaces 3a2 and 4a2 of the two sides of the recess 5 opposing to such rising surfaces 27d2 is formed as a plane that covers each rising surface 27d2 from the top.

FIG. 6 is a side view illustrating a third variant of the shape of the rising surfaces of the two sides of the recess 5 and the shape of the two sides of the slide tray 27. In the third variant depicted in FIG. 6, rising surfaces 27d3 of the slide tray 27 (cross-sectional shape orthogonal to the first slide direction) has a widened shape that widens downward step-wise. Rising surfaces 3a3 and 4a3 of the two sides of the recess 5 opposing to such rising surfaces 27d3 is formed as a stepped surface that covers each rising surface 27d3 from the top.

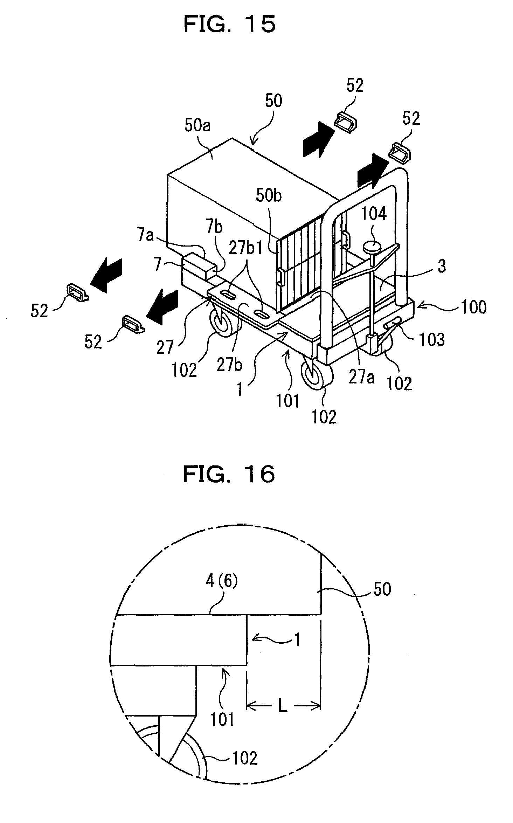

By adapting the shape depicted in FIG. 5 or FIG. 6, the sides of the flaps 27b and 27c of the slide tray 27 are held by the rising surfaces 3a2 and 4a2, or 3a3 and 4a3. This can reliably prevent any upward movement of the flaps 27b and 27c from the upper surface 2a of the mount jig 1. When the flaps 27b and 27c move upward while the product 50 is displaced to the second slide direction (rear direction) (see FIGS. 14 and 15), they might interfere with the rack attachment section 50b of the product 50, hindering slidable displacement of the product 50. Therefore, when the shape depicted in FIG. 5 or FIG. 6 is not adapted, any securing by means of tape or the like is provided to prevent any upward movement of the flaps 27b and 27c. Adapting the shape depicted in FIG. 5 or FIG. 6, however, can prevent any upward movement of the flaps 27b and 27c, eliminating needs for securing by means of tape.

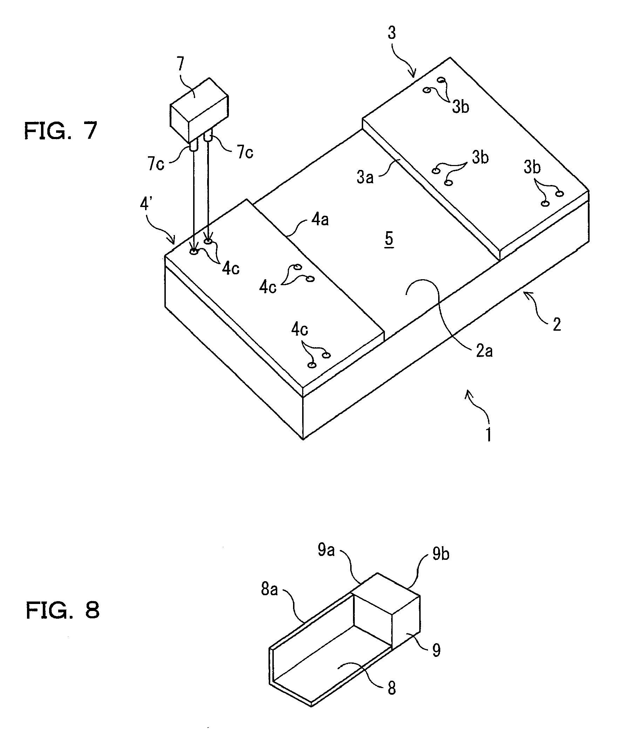

FIG. 7 is a perspective view illustrating a variant of an attachment structure of the block (restricting member) 7. In the mount jig 1 depicted in FIGS. 1-3, the block 7 is attached using an adhesive material or double-sided tape or the like. In contrast, in the variant depicted in FIG. 7, a rear-side sheet member 4' without any cutout section 4b, in place of the rear-side sheet member 4, is attached to the upper surface 2a of the cover member 2. A plurality of attachment holes 3b and 4c are formed in each of the front-side sheet member 3 and the rear-side sheet member 4'. That is, in order to selectively attach the block 7 on at least one of a plurality of locations on the cover member 2, the attachment holes 3b and 4c are formed as a plurality of securing section to detachably secure the block 7 at the plurality of locations. The attachment holes 3b and 4c are a pair of holes, and the block 7 is detachably secured on the cover member 2 by inserting a pair of attachment projections 7c projectedly provided on the bottom of the block 7 into the attachment holes 3b and 4c. In the example depicted in FIG. 7, the attachment holes 3b are provided in three locations (the rear center, the front left, and the front right) of the front-side sheet member 3, and the attachment holes 4c are provided in three locations (the front center, the rear left, and the rear right) of the rear-side sheet member 4'.

By adapting such an attachment structure, an operator does not need to pay attention to the front-and-back direction of the mount jig 1 when installing the mount jig 1 (the cover member 2) on the table 101 of the elevating lift 100. After installing the cover member 2, what the operator is to do is to attach the block 7 on a desired location. In addition, if a passage as a working space in front of the rack 60 is narrow when the product 50 is mounted on the rack 60, the product 50 is required to be rotated on the elevating lift 100 by 90° from the position depicted in FIG. 14, for example. In such as case, it is possible to restrict, any rotation of the product 50 by attaching the block 7 to the attachment holes 3b at the rear center on the front-side sheet member 3 or the attachment holes 4c at the front center on the rear-side sheet member 4', for example. It should be noted that locations to provide the attachment holes 3b and 4c are not limited to the six locations as depicted in FIG. 7, and higher flexibility for various scenarios can be achieved by providing more attachment holes in the block 7.

FIG. 8 is a perspective view illustrating a variant of a restricting member. In the examples depicted in FIGS. 1-3 and 7, the box-shaped block 7 is used as a restricting member. In contrast, in the variant depicted in FIG. 8, in place of the block 7, two restricting members, i.e., a restricting plate 8 and a block 9, are used. The restricting plate 8 and the block 9 are attached to the upper surface 2a exposed by the cutout section 4b of the rear-side sheet member 4, using an adhesive material or double-sided tape or the like, as depicted in FIG. 8. The restricting plate (first restricting member) 8 includes a first restricting surface 8a, and the block (second restricting member) 9 includes a first restricting surface 9a and a second restricting surface 9b. The first restricting surfaces 8a and 9a are adapted to function similar to that of the above-described first restricting surface 7a, and restrict any displacement of the product 50 to the first slide direction (right direction) by abutting against the right-side surface of the product 50. The first restricting surfaces 8a and 9a are aligned on the same plane, and are planes that are orthogonal to the upper surface 2a and are parallel to the lateral direction. In addition, the second restricting surface 9b is adapted to function similar to that of the above-described second restricting surface 7b, and upon displacing the product 50 to the second slide direction so as to mount it from the elevating lift 100 to the rack 60, the second restricting surface 7b restricts any displacement of the product 50 to the second slide direction by abutting against the right-side rack attachment section 50b of the product 50. The front end surface of the block 9 defines the second restricting surface 9b. Since advantageous effects achieved by the first restricting surfaces 8a and 9a and the second restricting surface 9b are similar to the advantageous effects the first restricting surface 7a and the second restricting surface 7b described above, any description thereof is omitted.

### (2) Configuration of Packing Box

Next, the entire configuration of the packing box (packed body) 20 will be described with reference to FIG. 10. It should be noted that, similar to the jig 1, also in the following description, the front, the rear, the left, and the right of the packing box 20 are defined as depicted in FIG. 10 for ease of description. FIG. 10 is an exploded perspective view of the packing box 20 of the product 50.

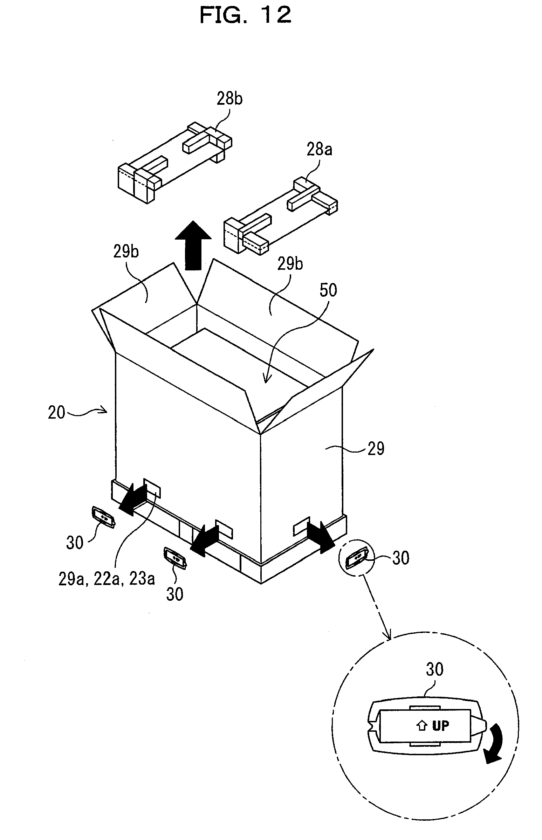

The packing box 20 includes a base section 21. The base section 21 includes an outer box 22 having an open top and an inner box 23 to be enclosed into the outer box 22 and having an open top. Since the outer box 22 has the open top, it can easily receive the inner box 23 therein. The outer box 22 has a beam 25 at the bottom thereof. In addition, the outer box 22 has insert slots 22a for receiving joints 30 (see FIGS. 11 and 12).

Six pillars 23b are disposed inside the inner box 23. The pillars 23b are respectively formed from plural sheets of corrugated cardboard that are stacked and adhered together. The pillars 23b function to reinforce the base section 21. More particularly, the product 50, which is an article to be mounted, is placed on the base section 21. Since the product 50 is a heavy article, the dimensions, shapes, and placements of the pillars 23b are determined, for supporting the weight of the product 50. Insert slots 23a for receiving the joints 30 are also provided in the inner box 23, so as to be aligned with the insert slots 22a in the outer box 22.

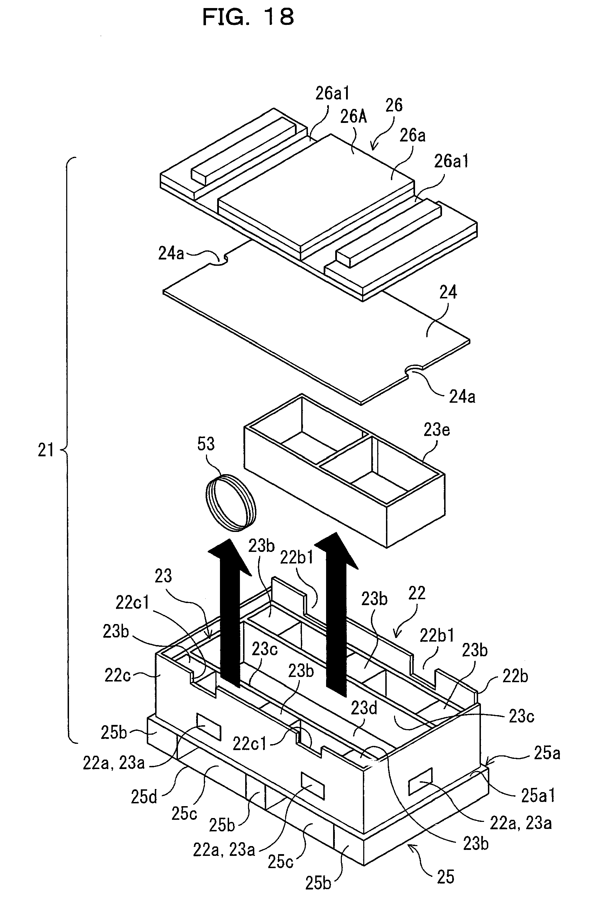

The space inside the inner box 23 can be used for an accommodating section of supplemental parts, such as a power supply connector 53 (see FIG. 18). Since the inner box 23 has the open top, the supplemental parts can be easily accommodated into the inner box 23. As a result, supplemental parts can be easily taken out from or enclosed into the inner box 23. Two partitioning plates 23c are disposed around the pillars 23b inside the inner box 23, the accommodating space 23d is defined between the pillars 23b and the partitioning plates 23c. A partitioning member 23e is interposed in the space 23d between the two partitioning plates 23c, and various supplemental parts are accommodated in each of a plurality of accommodating spaces partitioned by the partitioning member 23e.

The left-side surface 22b of the outer box 22 is designed to be higher than the right-side surface 22c of the outer box 22. The height of the right-side surface 22c of the outer box 22 is designed to be the same as the height of an article placement surface 26A of a buffer member 26 (which will be described later) or slightly lower than that height. The height of the left-side surface 22b of the outer box 22 is designed to be higher than the height of the right-side surface 22c of the outer box 22, i.e., the height of the article placement surface 26A of the buffer member 26. This can prevent the slide tray 27 and the product 50 from being pulled toward the left direction erroneously. Two cutout sections 22b1 are formed in the left-side surface 22b so as to be aligned with two grooves 26a1 in the buffer member 26 (which will be described later). Similarly, two cutout sections 22c1 are formed in the right-side surface 22c so as to be aligned with two grooves 26a1 in the buffer member 26 (which will be described later). It should be noted that the height of the inner box 23 is designed to be lower than the height of the cutout sections 22b 1 and 22c 1 of the outer box 22.

The beams 25 are formed by attaching the three beam materials 25b extending along the lateral direction between two upper and lower backing boards 25a and 25d. Two fork insertion slots 25c for a fork lift are defined by placing the three beam materials 25b spaced apart each other. The beam materials 25b are formed from plural sheets of corrugated cardboard that are stacked and adhered together. The outer dimension of the backing boards 25a and 25d are designed to be greater than the outer dimension of the outer box 22 so that an exterior member 29 is placed on the outer rim 25a1 of the backing board 25a. The beams 25 are attached to the bottom of the outer box 22 by adhering to it.

The base section 21 includes a top plate (reinforcing sheet) 24. The top plate 24 is disposed inside the outer box 22, and is placed on the pillars 23b in the inner box 23. Cutout sections 24a in a hemi-circle shape are formed in the two lateral edges of the top plate 24. An operator can see the inside of the inner box 23 through the cutout sections 24a to check the inside of the inner box 23. In addition, the operator can hang his fingers in the cutout sections 24a to lift up the top plate 24 for removing the top plate 24.

The buffer member 26 is placed above the top plate 24. The buffer member 26 defines an article placement section. The upper surface of the buffer member 26 defines an article placement surface 26A. Hereinafter, the relationship between the article placement surface 26A of the base section 21 and the level of the table surface 101a of the table 101 included in the elevating lift 100 will be described. When the elevating lift 100 is located on the same floor surface as the base section 21 and the table 101 is lowered to its lowest level, the article placement surface 26A is located higher than the level of the table surface 101a. It should be noted that the table 101 of the elevating lift 100 is not necessarily lowered to its lowest level, the article placement surface 26A may be any level as long as it is higher than the level of the table surface 101a. The buffer member 26 is formed to have an increased height so that such a positional relationship is established. It should be noted that, when an article to be packed is pack without disposing the buffer member 26, the top plate 24 defines an article placement section and the upper surface thereof defines an article placement surface. In this case, the level of the article placement surface is set to be higher than the level of the table surface 101a of the elevating lift 100.

The buffer member 26 is divided into three sections. The buffer member 26 includes a base block 26a that receives the load of the product 50, which is an article to be mounted. In addition, the buffer member 26 includes a front-side block 26b and a back-side block 26c located in front and rear of the base block 26a, respectively. The front-side block 26b and the back-side block 26c are interposed between the base block 26a and the product 50 from the front and rear of the product 50, respectively, upon packing the product 50, thereby restricting any displacement of in the product 50 to the back-and-forth and lateral directions. In addition, the base block 26a includes two grooves 26a1. The grooves 26a1 are formed to be aligned with the cutout sections 22b1 and 22c1 of the outer box 22 described above, and are used for removing a hanging string used for hanging the product 50 during shipment packing. In such a buffer member 26, only the base block 26a receives the load. Thus, the front-side block 26b and the back-side block 26c can be easily removed while the product 50 is placed on the buffer member 26.

The slide tray 27, which was described above with reference to FIG. 3, is placed on the article placement surface 26A of the buffer member 26, and the product 50 is placed on the slide tray 27. Accordingly, the slide tray 27 is located below the product 50, which is an article to be mounted. Above the product 50, an upper front buffer member 28a and an upper rear buffer member 28b are interposed between the product 50 and the exterior member 29, thereby restricting any displacement of the product 50 in the back-and-forth and lateral directions. Furthermore, a rack kit (rail kit) 54 and installation manual 55 (see FIG. 11) are accommodated above the buffer members 28a and 28b.

The packing box 20 includes the exterior member 29 that is placed on the buffer member 26, and covers the product 50 covered by the buffer members 28a and 28b. The exterior member 29 is a box, and covers around the staked body from the base section 21 to the buffer members 28a and 28b. Insert slots 29a for receiving the joints 30 are also provided in the exterior member 29, so as to be aligned with the insert slots 22a in the outer box 22 and insert slots 23a in the inner box 23. In addition, the exterior member 29 also includes a lid section 29b that is upwardly openable.

Once the staked body from the base section 21 to the buffer members 28a and 28b is covered by the exterior member 29 and the six joints 30 are attached, as depicted in FIG. 11, the packing procedure using the packing box 20 is completed. Once the joints 30 are inserted and locked into the inserts slot 29a, 22a, and 23a, which are aligned with each other, the exterior member 29, the outer box 22 and the inner box 23 are secured together.

It should be noted that, corrugated cardboard is used as the material for the packing box 20, except for the buffer members 26, 28a, and 28b made of a foamed material.

### (3) Procedure for Packing Article to be mounted

Next, the procedure for packing the product (article to be mounted) 50 using the above-described packing box 201 will be described with reference to FIG. 10.

Firstly, the inner box 23 is received within the outer box 22 having the beams 25 attached thereon. In addition, supplemental parts, such as the power supply cable 53, are received within the accommodating space 23d of the inner box 23. The top plate 24 is then placed on the pillars 23b in the inner box 23, and the base block 26a is placed on the top plate 24. Thereafter, the slide tray 27 is placed on the article placement surface 26A of the base block 26a. A package or wrapping paper for wrapping the product 50 may be displaced on the slide tray 27.

The product 50 is then placed on the base block 26a. The product 50 is assembled in a factory by installing required electronic devices 51 into an apparatus main body 50a and undergoes various tests. After the product 50 passes the tests, the product 50 is packed in the packing box 20 without any connector being disconnected or being disassembled.

When the product 50 is placed on the article placement surface 26A of the base block 26a, a hanging string (not depicted) is tied around the product 50. The hanging string is tied around the product 50 so as to be aligned with the positions of the grooves 26a1 provided in the base block 26a. The product 50 is hung by the hanging string, and moved on the base block 26a. After moving the product 50 on the article placement surface 26A, the hanging string can be easily removed through the grooves 26a1 provided in the base block 26a and the cutout sections 22b1 and 22c1. After placing the product 50 on the article placement surface 8, the flap 27b of the slide tray 27 is secured by tape so as to prevent it from being opened. In addition, the front-side block 26b and the back-side block 26c are interposed between the product 50 and the base block 26a from the front and rear, respectively.

Next, the buffer members 28a and 28b are placed above the product 50, and the rack kit 54 and the installation manual 55 are accommodated above the buffer members 28a and 28b. Thereafter, the exterior member 29 is placed, with its lid sections 29b being closed. The exterior member 29 is placed on the outer rim 25a1 of the beam 25 while the lower edge of the exterior member 29 abutting against the outer rim 25a1. Then, the outer box 22, the inner box 23, and the exterior member 29 are secured by the joints 30. The procedure for packing the product 50 is completed. The product 50 packed in the packing box 20 is shipped and transported to a site where the product 50 is to be set up. When the packing box 20 is moved or loaded onto a track or the like, a fork of a fork lift is inserted into the fork insertion slots 25c to lift the packing box 20.

### (4) Procedure for Unpacking/moving installation of Article to be mounted

Next, the procedure for unpacking the packing box 20 on a site where the product (article to be mounted) 50 is set up, as well as the procedure for moving installation of the product 50 using the mount jig 1, will be described with reference to FIGS. 11-18. As depicted in FIG. 17, the explanation will be given with reference to an example in which the product 50 is moved into the rack 60 located rear of the product 50 while the product 50 is moved backward with respect to the rack 60. Before unpacking the packing box 20, the elevating lift 100 is placed adjacent to the packing box 20. It should be noted that, in the configuration of the packing box 20 of this embodiment, the elevating lift 100 is placed adjacent to the right of the product 50/the packing box 20.

First, an operator opens the lid sections (top surfaces) 29b of the exterior member 29, and removes the rack kit 54 and the installation manual 55, as depicted in FIG. 11. The operator then removes the upper front buffer member 28a and the upper rear buffer member 28b, unlocks the joints 30 at six locations around the exterior member 29, and lifts the exterior member 29 for removing it, as depicted in FIG. 12. The removed rack kit (rail kit) 54 is installed in the rack 60 (see FIG. 17).

The operator then moves the elevating lift 100 adjacent to the right of the product 50/the packing box 20, and removes the front-side block 26b and the back-side block 26c, as depicted in FIG. 13. Since the blocks 26b and 26c do not receive the load of the product 50, they can be easily removed. The mount jig 1 (the cover member 2) has been installed on the table 101 of the elevating lift 100. The operator has adjusted the level of the table 101 by operating the foot pedal 103 and the handle 104 of the elevating lift 100. The operator adjusts the level of the table 101 such that the level of the upper surface 2a of the recess 5 in the mount jig 1 is the same as the level of the article placement surface 26A of the base section 21. It should be noted that the level of the table surface 101a (the upper surface 2a of the recess 5) is adjusted so as to be slightly lower than the article placement surface 26A, as long as no impact is given to the product 50. In addition to adjusting the level of the table surface 101a, the operator adjusts the position of the elevating lift 100 so that the position of the recess 5 in the mount jig 1 is aligned with the position of the slide tray 27, and locks the wheels 102 after the adjustments are completed.

Thereafter, the operator peels off the tape (not illustrated) used to secure the right-side flap 27b of the slide tray 27 to open the flap 27b. The operator then hands his fingers on the handling holes 27b1 of the right-side flap 27b and the handles 52 on the right-side surface of the product 50 to pull the slide tray 27 and the product 50 to first slide direction (right direction) A1. In response, the slide tray 27 having the product 50 placed thereon is slidably displaced along the recess 5 to the first slide direction (right direction) A1 while sliding on the low friction sheet 6 of the upper surface 2a of the recess 5. In addition, the product 50 is slidably displaced to the first slide direction (right direction) A1 along with the slide tray 27 by making the section of the bottom protruding from the slide tray 27 contact to the low friction sheet 6 on the upper surfaces of the sheet members 3 and 4 while sliding on the sheet 6. Thereby the heavy product 50 can be easily displaced onto the table 101 (the mount jig 1). Even when the product 50 is displaced forcefully, the rear and right sides of the product 50 abuts against the first restricting surface 7a of the block 7. Thus, the product 50 can be safely moved from the packing box 20 onto the table surface 101a of the elevating lift 10 (the mount jig 1), and does not slip off from the elevating lift 100, as depicted in FIG. 14. It should be noted that, since the block 7 is made from a soft material, such as a polyethylene foam, rubber, as described above, it is ensured that any damage to the product 50 is prevented when the product 50 touches to the block 7.

As depicted in FIG. 14, once the product 50 displaces the slide tray 27 and the product 50 until touching to the first restricting surface 7a of the block 7, the operator secures the flaps 27b and 27c of the two sides of the slide tray 27 to the upper surface of the mount jig 1 by means of tape. This is done for preventing the flaps 27b and 27c from moving upward while the product 50 is displaced to the second slide direction A2 and interfering with the rack attachment section 50b of the product 50. However, if the shape depicted in FIG. 5 or FIG. 6 is adapted, the sides of the flaps 27b and 27c of the slide tray 27 are held by the rising surfaces 3a2 and 4a2, or 3a3 and 4a3. This can reliably prevent any upward movement of the flaps 27b and 27c from the upper surface 2a of the mount jig 1. Thus, since any upward movement of the flaps 27b and 27c can be prevented, needs for securing by means of tape is eliminated. It should be noted that the operator hands his fingers on the handling holes 27b1 of the flap 27b, which is prevented from being moved upward, and pulls the slide tray 27.

The operator then grabs the handles 52 on the two sides of the product 50 positioned as depicted in FIG. 14, and pulls to the second slide direction (rear direction) A2. In response, the product 50 is displaced to the second slide direction (rear direction) A2 while sliding on the sheet members 3 and 4 (the low friction sheet 6) and the slide tray 27 and being guided along the first restricting surface 7a of the block 7. The operator displaces the product 50 until the rear section of the product 50 protrudes from the table 101 by a predetermined amount L, and stops the displacement, as depicted in FIGS. 15 and 16. By protruding the rear section of the product 50 by the predetermined amount L, any interference between the wheels 102 and stabilizers 60a of the rack 60 (see FIG. 17) can be prevented when the elevating lift 100 is moved in front of the rack 60 for mounting the product 50 into the rack 60. This can facilitate mounting of the product 50 into the rack 60. The above-described predetermined amount L is about 17 cm, for example, and the value thereof is suitably selected according to the structure of the stabilizers 60a or the like. While the rear section of the product 50 is protruded by the predetermined amount L, the operator unscrews the attachment bolts 52a and removes the four handles 52 on the two sides of the product 50, as depicted in FIG. 15. It should be noted that any marking may be provided on the side of the product 50 such that the operator can confirm that the rear section of the product 50 is protruded from the table 101 by the predetermined amount L. For example, a marking of an arrow or the like may be provided on the side of the product 50 at the position of the predetermined amount L from the rear end. Thereby, the operator can make sure that the rear section of the product 50 is protruded from the table 101 by the predetermined amount L at the time when the arrow marking points the position of the rear end of the table 1.

Thereafter, the operator unlocks the wheels 102, and moves the elevating lift 100 to the front of the rack 60 to which the product 50 is to be mounted. The elevating lift 100 is then placed in front of the rack 60 having a suitable spacing therewith, so as not to contact to other devices that have been installed. Next, the operator then operates the foot pedal 103 so as to elevate the table surface 101a to the level of the rack kit 54 installed in the rack 60. Furthermore, the operator makes a fine adjustment to the level of the table surface 101a by operating the handle 104, and pushes the product 50 to slit to the direction of Arrow A3 (rear direction) on the first restricting surface 7a, as depicted in FIG. 17 so that the product 50 is mounted on the rear side of the rack kit 54 (rails). Once adjusting the level of the table surface 101a, the operator locks the wheels 102 of the elevating lift 100.

The operator further slidably displaces the product 50 to the direction of Arrow A3 (rear direction) on the first restricting surface 7a. At this time, so as to prevent the elevating lift 100 sunk due to the weight of the product 50 from rising and thus contacting to the product 50, the rack attachment section 50b of the product 50 abuts against the second restricting surface 7b of the block 7 at the position in which the product 50 is not completely inserted, thereby restricting further displacement of the product 50 to the direction of Arrow A3. It should be noted that the rack attachment section 50b preferably stops displacement of the product 50 before the product 50 contacts the second restricting surface 7b (for example, 1 mm frontward to the contract position). However, even if the rack attachment section 50b contacts the second restricting surface 7b, the block 7 does not damage the product 50 (the rack attachment section 50b) since the block 7 is made of a soft material, such as a polyethylene foam, rubber. When the rack attachment section 50b contacts the second restricting surface 7b, the operator displaces the product 50 to front to some degree, moving the rack attachment section 50b away from the second restricting surface 7b.

Since most of the load of the product 50 is shifted from the side of the elevating lift 100 to the side of the rack kit 54 at this stage, the handle 104 of the elevating lifter 100 is operated to gradually lower the table 101 to move all of the load of the product 50 to the side of the rack kit 54. After lowering the table 101 until the block 7 does not interferes with the rack attachment section 50b, the operator moves the elevating lifter 100 from the front of the rack 60. The operator then inserts the product 50 completely into the rack 60, and secures the product 50 to the rack 60 by screwing the attachment bolts 50b 1 of the rack attachment section 50b of the product 50.

Thereafter, the operator removes the buffer member 26, the reinforcing sheet 24, and the partitioning member 23e from the base section 21 of the packing box 20, as depicted in FIG. 18, and removes supplemental parts /accessories, such as the power supply connector 53 accommodated within the inner box 23. The product 50 becomes ready to be operated only by connecting the power supply connector 53. In other words, the electronic devices 51 have been mounted in the product 50, and they can be used immediately. Accordingly, further procedure to connect various connectors is not necessary, such as connecting among the electronic devices 51, or connecting among the electronic devices 51 and the product main body 50a. Since the product 50 has passed the various tests at the factory and no task is performed on it, the incidence rate of failures due to connections of the connectors is quite low.

As described above, by using the mount jig 1 and the packing box 20, the product 50 can be moved safely and smoothly from the packing box 20 to the elevating lift 100, and then from the elevating lift 100 to the rack 60. As a result, installation of the product 50 to an elevated location can be carried out easily and safely. In addition, it is possible to finish the procedure for setting up the product 50 on the site in a shorter time. Furthermore, it is possible to reduce the incidence rate of failures due to connections of the connectors. In addition, since individual packing of electronic devices 51 are not necessary, it is possible to save the exportation cost and the packaging materials.

### (5) Advantageous Effects obtained by Mount Jig and Packed Body of This Embodiment

Advantageous effects obtained by the mount jig 1 and the packing box 20 described above are summarized as follows:

With a simple procedure of covering the table 101 of the elevating lift 100 with the mount jig 1 (the cover member 2), it is possible to make the table surface 101a of the elevating lift 100 to be slidable irrespective presence of a rubber (nonskid surface treatment) or the like on the table surface 101a. In addition by combining the elevating lift 100 having the mount jig 1 mounted thereon and the packing box 20, procedure for moving on the elevating lift 100 to mount in the rack 60 can be safely, easily, and precisely without lifting the packed product 50 by human power. That is, even if the product 50 is a heavy article, it is possible to significantly easily and safely the procedures to moving the product 50 on the elevating lift or moving and installing to an elevated position of the product 50 from the elevating lift 100 to the rack 60. Accordingly, in addition to reducing the working time on site, the quality of the product on arrival can be increased since no connector is disconnected.

The packing box 20 is provided with the base section 21 having the article placement surface 26A at the position higher than the level of the table surface 101a of the elevating lift 100 when the table is lowered. In addition, the exterior member 29 is made detachable when the product 50 is placed on the article placement surface 26A. With this configuration, simply by elevating the table 101 to suitably adjust the level of the table surface 101a, it is easily slidably displace the product 50 on the article placement surface 26A and moves from the article placement surface 26A onto the table 101. That is, the product 50 can be unpacked and moves to on the elevating lift 100 without lifting it by human power. As a result, even if the product 50 is a heavy article, it is possible to move the product 50 onto the elevating lift 100.

In addition, since the slide tray 27 having the product 50 placed thereon slidably displaces while engaging with the recess 5 defined on the upper surface of the mount jig 1, the direction of the slidable displacement restricted substantially to one direction (the right direction in this embodiment). Thereby, slidable displacement of the product 50 can be performed precisely.

Furthermore, the block 7 (or the restricting plate 8 and the block 9) function(s) as a stopper when the first restricting surface 7a (or 8a and 9a) slidably displace(s) the product 50 from the packing box 20 to the elevating lift 100, and this stopper function reliably prevent any drop of the product 50. In addition, the first restricting surface 7a (or 8a and 9a) can be used as a guide member for slidably displacing, the product 50 to the second slide direction (rear direction). Furthermore, the second restricting surface 7b (or 9b) functions as a stopper when slidably displacing the product 50 from the elevating lift 100 to the rack 60, and this stopper function reliably prevents upward movement of the elevating lift 100. Accordingly, it is possible to reliably prevent the product 50 or any products that have been installed from contacting to the elevating lift 100 and from being damaged.

### (6) Others

While preferred embodiments of the invention have been described in detailed above, it should be understood that these are exemplary of the invention and are not to be considered as limiting. Any modifications and variations can be made without departing from the scope of the claims.

## Claims

1. A mounting jig comprising:
a cover member (2) that is detachably secured to a table (101) of an elevating lift (100) for receiving an article (50) to be mounted placed thereon for transportation, the cover member covering an upper surface of the table (101),
an upper surface of the cover member (2) being provided with a low friction treatment.

2. The mounting jig according to claim 1, wherein the cover member (2) has an inner shape that is configured to mate with an outer shape of the upper surface of the table (101), and the cover member (2) is arranged to be mated with the table (101) from the top, whereby the cover member being detachably secured to the table (101).

3. The mounting jig according to claim 1 or 2 wherein the low friction treatment comprises a low friction sheet (6) provided on the upper surface of the cover member (2).

4. The mounting jig according to any one of claims 1-3, wherein the upper surface of the cover member (2) has a recess (5) formed therein along a first sliding direction, the recess (5) engaging with a plate-shape sliding member (27) for sliding the article (50) toward the first sliding direction, so as to direct the sliding member (27), and
the height of protrusions (3, 4) on the two sides of the recess (5) with respect to the bottom of the recess (5) is the same as or slightly higher than the height of the sliding member (27).

5. The mounting jig according to claim 4, wherein the width of the recess (5) at the upper surface of the cover member (2) is slightly wider than the width of the sliding member (27).

6. The mounting jig according to claim 5, wherein rising surfaces on the two sides of the recess (5) protrude toward the sliding member (27).

7. The mounting jig according to claim 5, wherein the cross-section along the direction perpendicular to the first sliding direction of the two sides of the sliding member (27) has a downwardly widened shape, and rising surfaces on the two sides of the recess (5) are formed so as to cover the portions of the widened shape on the two sides of the sliding member (27).

8. The mounting jig according to any one of claims 4-7, further comprising a restricting member (8, 9) comprising a first restricting surface (8a, 9a) for abutting against the article (50) for restricting any displacement of the article (50) to the first sliding direction, and a second restricting surface (9b) for abutting against the article (50) for
restricting any displacement of the article (50) to a second sliding direction perpendicular to the first sliding direction.

9. The mounting jig according to claim 8, further comprising a plurality of securing sections (4c) for detachably securing the restricting member (8, 9) at each of a plurality of locations on the cover member (2) so as to selectively attach the restricting member (8, 9) at least one of the plurality of locations.

10. A elevating lift comprising:
a table (101) capable of being raised and lowered; and
the mounting jig (1) according to any one of claims 1-9 installed on the table (101).
